# EUROPÄISCHE PATENTANMELDUNG

(11) **EP 3 349 024 A1**
(43) Veröffentlichungstag der Anmeldung: **18.07.2018**
(21) Anmeldenummer: 17204825.8
(22) Anmeldetag: 01.12.2017
(51) Int. Cl.: G01R 31/34, H02P 29/00

(54) **GESCHALTETER RELUKTANZANTRIEB**

(30) Priorität: 11.01.2017 DE 102017100434
(71) Anmelder: Miele & Cie. KG, 33332 Gütersloh (DE)
(72) Erfinder: Sammoud, Hafedh, 8090 Kelibia (TN); Kiefer, Andreas, 53125 Bonn (DE)

(57) **Zusammenfassung**

Die Erfindung betrifft eine Messschaltung (2) zur Verwendung in einem Reluktanzantrieb mit einem Reluktanzmotor mit einem Stator mit mindestens einem ersten Strang (11) einer ersten Phase und einem zweiten Strang (12) einer zweiten Phase,
wobei die Messschaltung (2) ausgebildet ist, einen Ist-Strom (Iph1) eines ersten Strangs (11) und einen Ist-Strom (Iph2) eines zweiten Strangs (12) eines Stators eines Reluktanzmotors des Reluktanzantriebs zu erfassen,
dadurch gekennzeichnet, dass
die Messschaltung (2) einen Messwiderstand (25) aufweist, welcher sowohl mit dem ersten Strang (11) als auch mit dem zweiten Strang (12) derart elektrisch leitfähig verbunden werden kann, dass der Messwiderstand (25) sowohl vom Ist-Strom (Iph1) des ersten Strangs (11) als auch vom Ist-Strom (Iph2) des zweiten Strangs (12) durchflossen werden kann.

## Beschreibung

Die vorliegende Erfindung betrifft einen geschalteten Reluktanzantrieb gemäß dem Patentanspruch 9, eine Messschaltung gemäß dem Patentanspruch 1 zur Verwendung in einem derartigen Reluktanzantrieb sowie ein elektrisches Gerät gemäß dem Patentanspruch 11 mit einem derartigen Reluktanzantrieb.

Auf dem Gebiet der elektrischen Antriebe sind die geschalteten Reluktanzmotoren (engl. Switched Reluctance Rotor - SRM) bekannt, bei denen das Drehmoment im Rotor ausschließlich durch die Reluktanzkraft erzeugt wird.

Die Reluktanzkraft oder auch Maxwellsche Kraft tritt auf, wenn in einem Magnetfeld Materialien mit unterschiedlichen magnetischen Widerständen liegen. Dabei versucht die Reluktanzkraft den magnetischen Widerstand, der auch als Reluktanz bezeichnet wird, für den magnetischen Fluss zu minimieren. Mit der Verringerung des magnetischen Widerstandes steigt gleichzeitig die Induktivität.

Da Luft im Vergleich zu Eisenmaterial einen höheren magnetischen Widerstand aufweist, werden geschaltete Reluktanzmotoren geometrisch so aufgebaut, dass sie in Abhängigkeit der Rotorlage unterschiedliche magnetische Widerstände bzw. Induktivitäten aufweisen. Üblicherweise weist der Rotor eines geschalteten Reluktanzmotors ausgeprägte Pole auf und besteht aus geschichteten Elektroblechen. Der Stator besitzt ebenfalls ausgeprägte Pole die mit Spulen bewickelt sind. Die Anzahl der Rotor- und Statorpole ist passend zur Ansteuerung und gewünschten Anwendung zu wählen.

Im Gegensatz zu anderen Motortypen ist der geschaltete Reluktanzmotor sehr einfach und robust aufgebaut, da der Rotor keine Wicklungen oder Permanentmagnete benötigt. Auch entfallen prinzipbedingt jede Art von verschleißanfälligen Kohlebürsten oder Kollektoren.

Zur Ansteuerung des geschalteten Reluktanzmotors ist es notwendig, die Rotorlage relativ zu den Statorpolen zu kennen, damit die einzelnen Spulenstränge zum richtigen Zeitpunkt bestromt werden. Dies geschieht üblicherweise über einen Rotorlagegeber. Dies verursacht jedoch Aufwand und Kosten, außerdem führt der Rotorlagegeber zu einer größeren Defektwahrscheinlichkeit.

Daher ist eine sensorlose Ansteuerung bekannt, bei der für alle Phasen bzw. für alle Stränge der jeweilige Ist-Strom gemessen wird. Dies erfolgt üblicherweise über einen Messwiderstand in Form eines Shunts, wobei für jeden Strang ein Shunt vorhanden ist. Üblicherweise benötigt jeder Shunt eine Verstärkerschaltung. Beispielsweise kann bei einem zweiphasigen Reluktanzmotor die Messung des Ist-Strom der aktiven Phase durchgeführt werden, um eine Stromregelung realisieren zu können. Gleichzeitig kann der Ist-Strom der inaktiven Phase erfasst werden, um die Amplitude der Testströme für eine optimale Kommutierung zu bestimmen. Die Phasenströme fließen somit unabhängig voneinander über den jeweiligen Shunt und die Abtastung der Messwerte erfolgt jeweils für das erfasste Messsignal.

Auch wenn bei einer derartigen sensorlosen Ansteuerung auf den Aufwand und die Kosten eines Rotorlagegebers verzichtet werden kann, ist doch für jeden Strang ein Messwiderstand und üblicherweise eine Verstärkerschaltung erforderlich. Dies bedeutet immer noch einen nicht unerheblichen Aufwand mit entsprechenden Kosten. Dabei steigen der Aufwand und die Kosten mit jedem zusätzlichen Strang des Reluktanzmotors an.

Der Erfindung stellt sich somit das Problem, einen geschalteten Reluktanzantrieb der eingangsbeschriebenen Art bereitzustellen, bei dem die Erfassung der Ist-Ströme der Phasen bzw. Stränge einfacher und bzw. oder kostengünstiger erfolgen kann als bisher bekannt. Insbesondere soll die Messschaltung zur Erfassung der Ist-Ströme der Phasen bzw. Stränge einfacher und bzw. oder kostengünstiger und bzw. oder kompakter als bisher bekannt aufgebaut werden können.

Erfindungsgemäß wird dieses Problem durch einen geschalteten Reluktanzantrieb mit den Merkmalen des Patentanspruchs 9, durch eine Messschaltung mit den Merkmalen des Patentanspruchs 1 sowie durch ein elektrisches Gerät mit den Merkmalen des Patentanspruchs 11 gelöst. Vorteilhafte Ausgestaltungen und Weiterbildungen der Erfindung ergeben sich aus den nachfolgenden Unteransprüchen.

Somit betrifft die vorliegende Erfindung einen Reluktanzantrieb mit einem geschalteten Reluktanzmotor mit einem Stator mit einem ersten Strang und mit einem zweiten Strang und mit einer Messschaltung, welche ausgebildet ist, einen Ist-Strom des ersten Strangs und einen Ist-Strom der Summe beider Stränge zu erfassen. Der erste bzw. zweite Strang des Reluktanzmotors kann auch als erste bzw. zweite Phase des geschalteten Reluktanzmotors bezeichnet werden.

Der erfindungsgemäße geschaltete Reluktanzmotor ist dadurch gekennzeichnet, dass die Messschaltung einen Messwiderstand aufweist, welcher sowohl mit dem ersten Strang als auch mit dem zweiten Strang derart elektrisch leitfähig verbunden ist, dass der Messwiderstand sowohl vom Ist-Strom des ersten Strangs als auch vom Ist-Strom des zweiten Strangs durchflossen werden kann.

Auf diese Weise kann erfindungsgemäß ein gemeinsamer Messwiderstand verwendet werden, um die jeweiligen Ist-Ströme der beiden Stränge zu erfassen. Sind mehr als zwei Stränge vorhanden, können weiterhin die Ist-Ströme aller Stränge über lediglich einen Messwiderstand erfasst werden. Somit kann auf zusätzliche Messwiderstände des zweiten Strangs und ggfs. weiterer Stränge verzichtet werden. Hierdurch kann die Messschaltung vereinfacht werden, so dass Kosten und bzw. oder Bauraum gespart werden können.

Gemäß einem Aspekt der vorliegenden Erfindung ist der Messwiderstand ein Shunt. Unter einem Shunt wird ein niederohmiger elektrischer Widerstand verstanden, welcher zur Messung des elektrischen Stromes verwendet werden kann. Der Strom, der durch einen Shunt fließt, verursacht einen zu ihm proportionalen Spannungsabfall, der gemessen wird. Hierdurch kann eine einfache und genaue Erfassung des Ist-Stroms erfolgen.

Gemäß einem weiteren Aspekt der vorliegenden Erfindung weist die Messschaltung ferner eine integrierte Schaltung auf, die ausgebildet ist, den Ist-Strom des Messwiderstands zu einem ersten Zeitpunkt als Ist-Strom des ersten Strangs und zu einem zweiten Zeitpunkt als Ist-Strom beider Stränge zu erfassen. Mit anderen Worten ist die integrierte Schaltung ausgebildet, den Ist-Strom des Messwiderstands abwechselnd um eine Zeitdifferenz versetzt als Ist-Strom des ersten Strangs und als Ist-Strom der Summe beider Stränge zu erfassen. Aus dem Stromwert des ersten Stranges und der Summe des ersten und zweiten Stranges wird in der weiteren Auswertung der Strom des zweiten Stranges ermittelt.

Diesem Aspekt liegt die Erkenntnis zugrunde, dass die Amplitude des Testimpulses in der inaktiven Motorphase deutlich höher ist als die Stromamplitude der aktiven Phase. Daher kann auch ein Ripple auf dem Hauptstrom der aktiven Phase bei der Bewertung des Testimpulses vernachlässigt werden.

Somit kann erfindungsgemäß die Messung der Ist-Ströme an lediglich einem Strang vorgenommen werden, der während eines ersten Zeitpunkts bzw. eines ersten Zeitraums als Messwiderstand des ersten Strangs und während eines zweiten Zeitpunkts bzw. eines zweiten Zeitraums als Messwiderstand des zweiten Strangs betrachtet werden kann. Hierdurch stören sich die beiden oder auch weitere Messungen nicht und es kann auf einen weiteren Messwiderstand oder noch weitere Messwiderstände verzichtet werden. Dies kann auch als sequentielle Abtastung des Ist-Stroms des Messwiderstands bezeichnet werden.

Gemäß einem weiteren Aspekt der vorliegenden Erfindung weist die integrierte Schaltung ein erstes Verzögerungsglied, welches ausgebildet ist, den Ist-Strom des ersten Strangs entweder weiterzuleiten oder zu sperren, und ein zweites Verzögerungsglied auf, welches ausgebildet ist, den Ist-Strom des zweiten Strangs entweder weiterzuleiten oder zu sperren, wobei die beiden Verzögerungsglieder gegensinnig geschaltet werden können. Mit anderen Worten können die beiden Verzögerungsglieder derart geschaltet werden, dass das eine Verzögerungsglied den Ist-Strom weiterleitet während das andere Verzögerungsglied den Ist-Strom sperrt.

Hierdurch kann eine abwechselnde bzw. wechselseitige Messung der Ist-Ströme der beiden Stränge am gemeinsamen Messwiderstand ermöglicht werden, so dass sicher lediglich einer der beiden Stromwerte erfasst werden kann.

Weist der geschaltete Reluktanzmotor mehr als zwei Stränge auf, so sind entsprechend mehr Verzögerungsglieder vorzusehen und derart zu schalten, dass stets lediglich ein einziges Verzögerungsglied den Ist-Strom weiterleiten kann.

Gemäß einem weiteren Aspekt der vorliegenden Erfindung weist die integrierte Schaltung einen Analog-Digital-Wandler auf, welcher ausgebildet ist, die analogen Werte des Ist-Stroms des ersten Strangs und des Ist-Stroms des zweiten Strangs als digitale Werte auszugeben. Auf diese Weise können die gemessenen analogen Werte der Ist-Ströme digital zur weiteren Verarbeitung bereitgestellt werden, so dass auf die hierzu erforderliche analog-digitalWandlung an anderer Stelle verzichtet werden kann.

Gemäß einem weiteren Aspekt der vorliegenden Erfindung weist die Messschaltung ferner eine Verstärkerschaltung auf, die ausgebildet ist, den Ist-Strom des Messwiderstands zu verstärken. Auf diese Weise kann die Messgenauigkeit erhöht werden, indem ein stärkeres Messsignal verwendet werden kann.

Gemäß einem weiteren Aspekt der vorliegenden Erfindung ist die Messschaltung ausgebildet, eine Spannung über den Messwiderstand zu erfassen und in den Ist-Strom des Messwiderstands bzw. in den Ist-Strom des ersten Strangs oder in den Ist-Strom des zweiten Strangs umzurechnen. Auf diese Weise kann eine Strommessung indirekt mittels einer Spannungsmessung und anschließende proportionale Umrechnung über den bekannten ohmschen Widerstandswert des Messwiderstands erfolgen. Dies kann die Erzeugung eines Messwertes der Ist-Ströme der beiden Stränge vereinfachen bzw. das Messergebnis verlässlicher machen.

Die vorliegende Erfindung betrifft auch eine Messschaltung zur Verwendung in einem Reluktanzantrieb wie zuvor beschrieben, wobei die Messschaltung ausgebildet ist, einen Ist-Strom eines ersten Strangs und einen Ist-Strom eines zweiten Strangs eines Stators eines Reluktanzmotors des Reluktanzantriebs zu erfassen, wobei die Messschaltung einen Messwiderstand aufweist, welcher sowohl mit dem ersten Strang als auch mit dem zweiten Strang derart elektrisch leitfähig verbunden werden kann, dass der Messwiderstand sowohl vom Ist-Strom des ersten Strangs als auch vom Ist-Strom des zweiten Strangs durchflossen werden kann. Mittels einer derartigen Messschaltung kann in Kombination mit einem Reluktanzmotor ein erfindungsgemäßer Reluktanzantrieb geschaffen werden.

Die vorliegende Erfindung betrifft auch ein elektrisches Gerät, insbesondere ein elektrisches Haushaltsgerät, insbesondere einen Staubsauger, mit einem Reluktanzantrieb wie zuvor beschrieben. Auf diese Weise können die Eigenschaften und Vorteile eines Reluktanzantriebs allgemein mit den Vorteilen, welche durch die erfindungsgemäßen Weiterentwicklungen eines Reluktanzantriebs geschaffen werden, kombiniert werden. Hierdurch kann ein insbesondere günstigeres elektrisches Gerät bereitgestellt werden. Dies kann insbesondere bei elektrischen Haushaltsgeräten wie z.B. bei Staubsaugern sehr vorteilhaft sein, weil ein Benutzer bei der Kaufentscheidung üblicherweise den Kaufpreis als wichtiges Kriterium ansehen kann.

Ein Ausführungsbeispiel der Erfindung ist in den Zeichnungen rein schematisch dargestellt und wird nachfolgend näher beschrieben. Es zeigt
- Figur 1: einen schematischen Schaltplan eines erfindungsgemäßen Reluktanzantriebs; und
- Figur 2: einen Verlauf über der Zeit von Schaltpulsen und gemessenen Ist-Strömen der Stränge eines geschalteten Reluktanzmotors des erfindungsgemäßen Reluktanzantriebs.

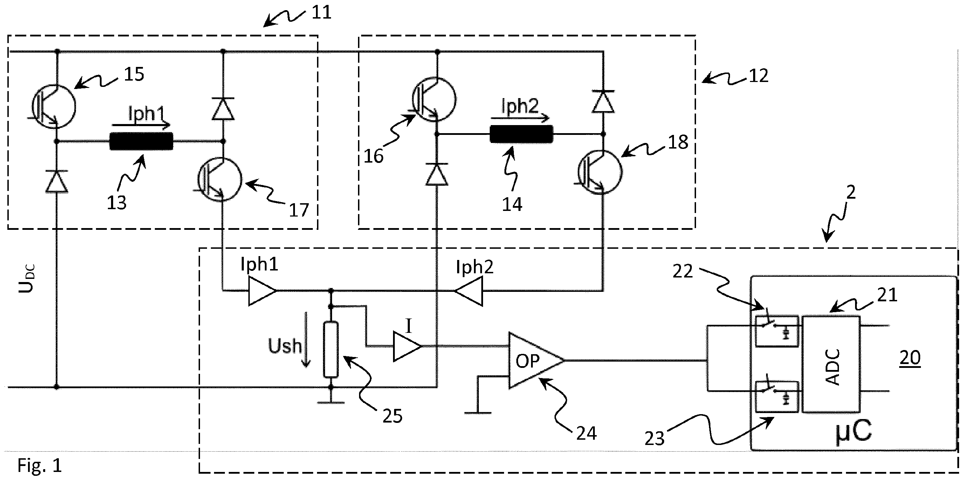

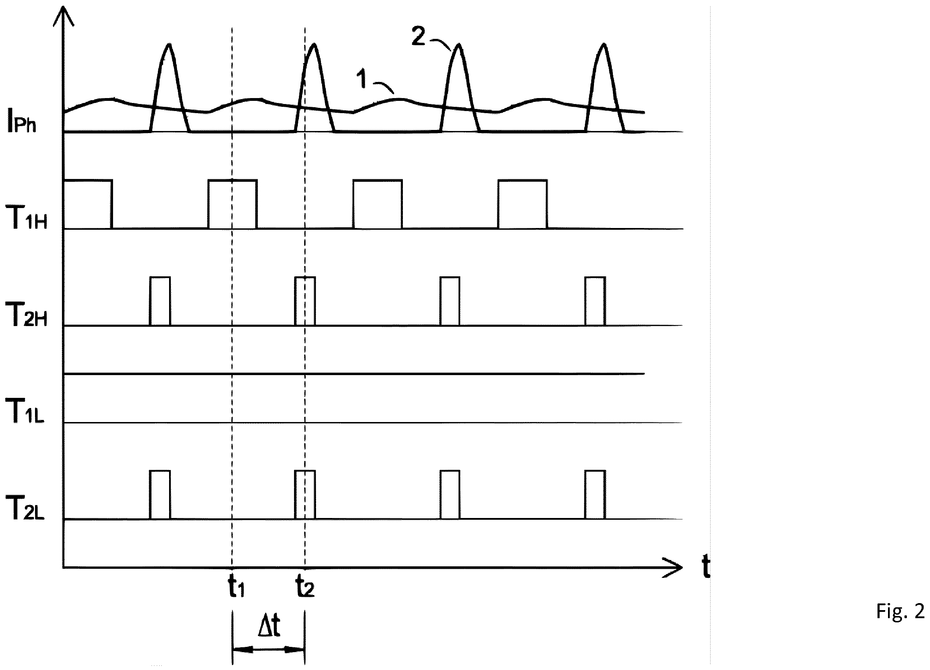

Figur 1 zeigt einen schematischen Schaltplan eines erfindungsgemäßen Reluktanzantriebs. Figur 2 zeigt einen Verlauf über die Zeit t von Schaltpulsen T1H, T1L, T2H, T2L der Leistungsschalter 15, 16, 17, 18 und gemessenen Ist-Strömen Iph1, Iph2 der Stränge 11, 12 eines geschalteten Reluktanzmotors des erfindungsgemäßen Reluktanzantriebs.

Der Reluktanzantrieb weist einen geschalteten Reluktanzmotor mit einem Stator auf. Der Reluktanzantrieb weist einen ersten Strang 11 und einen zweiten Strang 12 auf, welche auch als erste Phase 11 und zweite Phase 12 bezeichnet werden können. Der erste Strang 11 weist Statorwicklungen 13 auf, welche mittels eines ersten IGBT 15 des ersten Strangs 11 (Bipolartransistor mit isolierter Gate-Elektrode; englisch: insulated-gate bipolar transistor) und eines zweiten IGBT 17 des ersten Strangs 11 bestromt werden können. Der zweite Strang 12 weist Statorwicklungen 14 auf, welche mittels eines ersten IGBT 16 des zweiten Strangs 12 und eines zweiten IGBT 18 des zweiten Strangs 12 bestromt werden können.

Die Leistungsschalter können neben IGBTs auch Mosfets sein.

Durch die Statorwicklungen 13 des ersten Strangs 11 kann ein erster Ist-Strom Iph1 und durch die Statorwicklungen 14 des zweiten Strangs 12 kann ein zweiter Ist-Strom Iph2 fließen. Die Ist-Ströme Iph1, Iph2 der beiden Statorwicklungen 13, 14 können mittels pulsweitenmodulierter Spannungspulse T1L, T1H, T2L, T2H erzeugt werden (siehe Fig. 2), welche um eine Zeitdifferenz Δt gegeneinander versetzt sind, wobei die Zeitdifferenz Δt einer Phasenverschiebung von 180° entspricht.

Der Reluktanzantrieb weist ferner eine Messschaltung 2 auf, welche der Erfassung der beiden Ist-Ströme Iph1, Iph2 dient. Hierzu weist die Messschaltung 2 einen Messwiderstand in Form eines Shunts 25 auf, welcher elektrisch leitfähig mit beiden Strängen 11, 12 verbunden ist. Über dem Shunt 25 kann eine Spannung Ush abfallen, die proportional zu dem durch den Shunt fließenden Strom ist. Diese Spannung wird einer Verstärkerschaltung 24 in Form eines Operationsverstärkers 24 (OP) zugeführt, dessen anderer Eingang ebenso wie die andere Seite des Shunt 25 mit dem Null-Potential verbunden ist.

Das verstärkte Ausgangssignal des Operationsverstärkers 24 wird einer integrierten Schaltung 20 in Form eines Mikrokontrollers (µC) zugeführt. Als Bestandteil des Mikrokontrollers 20 ist ein Analog-Digital-Umsetzer 21 (ADC) mit vorgeschalteten Verzögerungsgliedern 22 und 23 vorgesehen.

Fig. 2 zeigt den Verlauf der Ansteuerung der Leistungsschalter 15, 16, 17, 18 der Schaltung aus Fig. 1, gemäß einer Ausführungsform der Erfindung. Die Eingangsspannung U_{DC}, beispielsweise aus einem Zwischenkreis, liegt an den oberen Leistungsschaltern 15, 16 an. In einem normalen Betrieb wird die aktive Phase (entspricht dies der Phase 11 aus Fig. 1) durch Schalten der Schalter 15 (T1H) und 17 (T1L) bestromt. Die Spannungshöhe an der Motorwicklung 13 der aktiven Phase kann durch ein getaktetes Schalten (hier: T1H) von mindestens einem Schalter (hier: 15) geregelt werden. Damit am Shunt 25 ein kontinuierlicher Strom gemessen werden kann, bleibt der untere Schalter 17 geschlossen (T1L).

Die inaktive Phase (entspricht dies der Phase 12 aus Fig. 1) wird durch Schalten (T2H, T2L) der Schalter 16, 18 angesteuert. Durch Einschalten beider Schalter 16, 18 ergeben sich Strompulse im Verlauf Iph2. Durch Auswertung dieser Strompulse kann auf die Rotorlage geschlossen werden und die Kommutierung entsprechend erfolgen.

Das Verzögerungsglied 22 initiiert die Umwandlung des analogen Signals der Spannung Ush, welches an dem Shunt 25 anliegt, zu einem Zeitpunkt t1, welches der Mitte des PWM-Signals T1H entspricht. Zum Zeitpunkt t1 fließt der Strom Iph1 durch den Shunt 25. Das abgetastete Wert der Spannung Ush zum Zeitpunkt t1 liefert somit ein dem Strom Iph1 proportionales Messergebnis. Das Verzögerungsglied 23 initiiert die Umwandlung des analogen Signals der Spannung Ush, welches an dem Shunt 25 anliegt, zu einem Zeitpunkt t2, welches der Mitte des PWM-Signals T2H entspricht. Zum Zeitpunkt t2 fließen sowohl der Strom Iph1 als auch Iph2 durch den Shunt 25. Der abgetastete Wert der Spannung Ush zum Zeitpunkt t2 liefert somit ein der Summe aus den Strömen Iph1 und Iph2 proportionales Messergebnis. Unter der Annahme, dass der Strom in der aktiven Phase 13 zwischen den Zeitpunkten t1 und t2 quasi konstant bleibt, kann durch Subtraktion des Messergebnisses des Analog-Digital-Umsetzers zum Zeitpunkt t1 vom Messergebnis des Analog-Digital-Umsetzers zum Zeitpunkt t2 die Amplitude des Stroms Iph2 berechnet werden.

### Bezugszeichenliste (Bestandteil der Beschreibung)

- Iph1: Ist-Strom des ersten Strangs 11 bzw. der ersten Phase 11
- Iph2: Ist-Strom des zweiten Strangs 12 bzw. der zweiten Phase 12
- t: Zeit
- t1: Erster Zeitpunkt zum Messen des ersten Strang- bzw. Phasenstromes
- t2: Zweiter Zeitpunkt zum Messen der Summe beider Strang- bzw. Phasenströme
- Δt: Zeitdifferenz zwischen beiden Messzeitpunkten
- T1L: Schaltpuls des unteren Leistungsschalters des ersten Strangs 11 bzw. der ersten Phase 11
- T1H: Schaltpuls des oberen Leistungsschalters des ersten Strangs 11 bzw. der ersten Phase 11
- T2L: Schaltpuls des unteren Leistungsschalters des zweiten Strangs 12 bzw. der zweiten Phase 12
- T2H: Schaltpuls des oberen Leistungsschalters des zweiten Strangs 12 bzw. der zweiten Phase 12

- Ush: Spannung über Messwiderstand 25

- 11: erster Strang bzw. erste Phase des Stators 10
- 12: zweiter Strang bzw. zweite Phase des Stators 10
- 13: Statorwicklungen des ersten Strangs 11 bzw. der ersten Phase 11
- 14: Statorwicklungen des zweiten Strangs 12 bzw. der zweiten Phase 12
- 15: erster IGBTs des ersten Strangs 11 bzw. der ersten Phase 11
- 16: erster IGBTs des zweiten Strangs 12 bzw. der zweiten Phase 12
- 17: zweiter IGBTs des ersten Strangs 11 bzw. der ersten Phase 11
- 18: zweiter IGBTs des zweiten Strangs 12 bzw. der zweiten Phase 12

- 2: Messschaltung für Reluktanzmotor
- 20, µC: integrierte Schaltung; Mikrokontroller
- 21, ADC: Analog-Digital-Wandler der integrierten Schaltung 20
- 22, Delay1: erstes Verzögerungsglied der integrierten Schaltung 20
- 23, Delay2: zweites Verzögerungsglied der integrierten Schaltung 20
- 24, OP: Verstärkerschaltung; Operationsverstärker
- 25: Messwiderstand; Shunt

## Patentansprüche

1. Messschaltung (2) zur Verwendung in einem Reluktanzantrieb mit einem Reluktanzmotor mit einem Stator mit mindestens einem ersten Strang (11) einer ersten Phase und einem zweiten Strang (12) einer zweiten Phase,
wobei die Messschaltung (2) ausgebildet ist, einen Ist-Strom (Iph1) eines ersten Strangs (11) und einen Ist-Strom (Iph2) eines zweiten Strangs (12) eines Stators eines Reluktanzmotors des Reluktanzantriebs zu erfassen,
**dadurch gekennzeichnet, dass**
die Messschaltung (2) einen Messwiderstand (25) aufweist, welcher sowohl mit dem ersten Strang (11) als auch mit dem zweiten Strang (12) derart elektrisch leitfähig verbunden werden kann, dass der Messwiderstand (25) sowohl vom Ist-Strom (Iph1) des ersten Strangs (11) als auch vom Ist-Strom (Iph2) des zweiten Strangs (12) durchflossen werden kann.

2. Messschaltung (2) gemäß Anspruch 1, wobei der Messwiderstand (25) ein Shunt (25) ist.

3. Messschaltung (2) gemäß Anspruch 1 oder 2, wobei die Messschaltung (2) ferner eine integrierte Schaltung (20) aufweist, die ausgebildet ist, den Ist-Strom des Messwiderstands (25) zu einem ersten Zeitpunkt (t1) als Ist-Strom (Iph1) des Strangs (11) der aktiven Phase und zu einem zweiten Zeitpunkt (t2) als Summe des Ist-Stroms (Iph1) des Strangs (11) der aktiven Phase und des Ist-Stroms (Iph2) des Strangs (12) einer inaktiven Phase zu erfassen, und die weiter ausgebildet ist, den Ist-Stroms (Iph2) des Strangs (12) der inaktiven Phase aus der Summe und dem Ist-Strom (Iph1) des Strangs (11) der aktiven Phase zu ermitteln.

4. Messschaltung (2) gemäß Anspruch 3, wobei die integrierte Schaltung (20) ein erstes Verzögerungsglied (22), welches ausgebildet ist, den Ist-Strom (Iph1) des Strangs (11) der aktiven Phase entweder weiterzuleiten oder zu sperren, und ein zweites Verzögerungsglied (23) aufweist, welches ausgebildet ist, die Summe des Ist-Stroms (Iph1) des Strangs (11) der aktiven Phase und des Ist-Stroms (Iph2) des Strangs (12) einer inaktiven Phase entweder weiterzuleiten oder zu sperren, und
wobei die beiden Verzögerungsglieder (22, 23) gegensinnig geschaltet werden können.

5. Messschaltung (2) gemäß Anspruch 3 oder 4, wobei die integrierte Schaltung (20) ausgebildet ist, den Ist-Strom (Iph1) des ersten Strangs (11) und den Ist-Strom (Iph2) des zweiten Strangs (12) pulsweitenmoduliert so zu erzeugen, dass der Messwiderstand (25) zu dem ersten Zeitpunkt (t1) von dem Ist-Strom (Iph1) des Strangs (11) der aktiven Phase und zu dem zweiten Zeitpunkt (t2) von der Summe des Ist-Stroms (Iph1) des Strangs (11) der aktiven Phase und des Ist-Stroms (Iph2) des Strangs (12) einer inaktiven Phase durchflossen wird.

6. Messschaltung (2) gemäß einem der Ansprüche 3 bis 5, wobei die integrierte Schaltung (20) einen Analog-Digital-Wandler (21) aufweist, welcher ausgebildet ist, die analogen Werte des Ist-Stroms (Iph1) des Strangs (11) der aktiven Phase und des Ist-Stroms (Iph2) der Summe des Ist-Stroms (Iph1) des Strangs (11) der aktiven Phase und des Ist-Stroms (Iph2) des Strangs (12) einer inaktiven Phase als digitale Werte auszugeben.

7. Messschaltung (2) gemäß einem der vorherigen Ansprüche, wobei die Messschaltung (2) ferner eine Verstärkerschaltung (24) aufweist, die ausgebildet ist, den Ist-Strom des Messwiderstands (25) zu verstärken.

8. Messschaltung (2) gemäß einem der vorherigen Ansprüche, wobei die Messschaltung (2) ausgebildet ist, eine Spannung (Ush) über den Messwiderstand (25) zu erfassen und in den Ist-Strom des Messwiderstands (25) umzurechnen.

9. Reluktanzantrieb, umfassend
einen Reluktanzmotor mit einem Stator mit mindestens einem ersten Strang (11) einer ersten Phase und einem zweiten Strang (12) einer zweiten Phase, und
eine Messschaltung (2) gemäß einem der Ansprüche 1 bis 8.

10. Reluktanzantrieb gemäß Anspruch 9, wobei der Reluktanzmotor eine oder mehrere weitere Phasen mit je einem weiteren Strang umfasst.

11. Haushaltgerät, insbesondere Staubsauger, umfassend einem Reluktanzantrieb gemäß einem der Ansprüche 9 oder 10.
